# EUROPEAN PATENT APPLICATION

(11) **EP 1 385 058 A1**
(43) Date of publication of application: **28.01.2004**
(21) Application number: 03254435.5
(22) Date of filing: 14.07.2003
(51) Int. Cl.: G03F 7/20

(54) **Lithographic apparatus and device manufacturing method**

(30) Priority: 16.07.2002 EP 02255002
(71) Applicant: ASML Netherlands B.V., 5503 LA Veldhoven (NL)
(72) Inventor: Van der Werf, Jan Evert, 5581 JA Waalre (NL); Fockert, George Arie Jan, 7323 CR Apeldoorn (NL); Van der Laan, Hans, 5501 CL Veldhoven (NL)
(74) Representative: Leeming, John Gerard

(57) **Abstract**

A reflector alignment system uses an alignment beam AB 1 propagating through a projection system PL comprising a mirror group to measure the apparent relative positions of two reference markers fixed to a reference frame RF on opposite sides of the projection system. Any movement of mirrors in the projection system PL will be detected as a shift in the apparent position of the reference markers 11, 14.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system comprising a plurality of reflectors for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

To meet the ever-present demand to be able to image smaller features, lithographic apparatus using extreme ultraviolet (EUV) radiation, e.g. with a wavelength in the range of from 5 to 20nm, are being developed. Because no material suitable for making refractive optical elements for EUV radiation is known, EUV lithography machines must use a reflective optical system to project the mask image onto a substrate. The positional accuracy, and to a lesser extent the quality, of images projected by reflective optical systems are, by the nature of these systems, very sensitive to errors and disturbances in the relative and absolute positions of the reflectors in the optical system. Accordingly it is necessary to mount the reflectors in the projection system of a lithography system very accurately and stably. However, the stability of mounting of the reflectors cannot be relied upon and it is therefore necessary to be able to detect errors and disturbances of the reflector positions. Such errors and disturbances can be detected in the developed images projected onto substrates or using a transmission image sensor in place of the substrate but this is time consuming and only provides a delayed indication of any problem.

It is an object of the present invention to provide a lithographic projection apparatus having an improved system to detect positional errors and disturbances of the reflectors in a projection system preferably in real-time or near real-time.

This and other objects are achieved according to the invention in a lithographic apparatus as specified in the opening paragraph, characterized by:
a reflector alignment system for directing an alignment beam of radiation through said projection system to measure the apparent relative positions of a first reference mark provided in a fixed position on the patterning means side of said projection system and a second reference mark provided in a fixed position on the substrate side of the projection system.

By measuring the apparent relative positions of two fixed reference marks using a beam that propagates through the projection system, a direct and real-time measurement of the positions of the reflectors in the projection system is possible - any movement of one or more reflectors will result in a shift in the apparent relative positions of the reference markers. The only delay in the measurement will be signal processing delays, which are small compared to the expected frequencies of disturbances of the reflectors.

Preferably, the numeric aperture (NA) of the alignment system is smaller than that of the projection system so that the reference marks (or folding mirrors used to direct the alignment beam) can be positioned outside the object and image fields of the projection lens and do not interfere with the exposure.

The alignment system may be of a type known for through-the-lens (TTL) alignment between reference marks in the mask (patterning means) and on the substrate with additional optics to direct the alignment beam to and from the fixed reference marks. Such systems are tried and tested and may be rapidly implemented in the invention - the additional optics required may be as simple as two folding mirrors. If an alignment system requiring a relative scan of the reference marks to operate is used, one of the marks may be implemented as a running fringe pattern formed by interference between two beams intersecting at a small angle. Alternatively, the reference and detection gratings can be given slightly different periods so that a beat pattern is generated. The phase of the beat pattern will depend on the relative position of the two gratings and can be detected relatively easily, *e.g.* with a CCD. In a further alternative, the ordinary (o) and extraordinary (e) components of the radiation are separated to fall on the detection grating at slightly different positions and a modulator between the detection grating and sensor transmits the o and e components alternately. The difference between o and e signals gives information about the relative position of the reference and detection gratings.

Preferably, the fixed reference marks are provided in planes congruent with the object and image planes of the projection system, where the patterning means and substrate are located during an exposure, so that the measured positional error directly corresponds to the error that will occur in the projected image.

One such alignment system can be used to measure lateral shifts in X- and Y-directions whilst two such alignment systems can be used to measure rotation and magnification changes as well as lateral shifts.

The errors detected by the alignment system may be compensated for, in most cases (e.g. where they result in a simple translation or rotation of the image), by adjustment of the position and/or orientation of the patterning means, the substrate and/or one or more of the reflectors in the projection system. If the projection system is non-telecentric, magnification errors may also be compensated for in the same way.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system comprising a plurality of reflectors,
characterized by the step of
- detecting positional errors or disturbances of the reflectors in said projection system by directing an alignment beam through the projection system to measure the apparent relative positions of first and second reference marks provided respectively at the patterning means side and the substrate side of said projection system.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a reflector system forming the projection system of the apparatus of Figure 1;
Figure 3 depicts the projection system and reflector alignment system of the apparatus of Figure 1;
Figure 4 is an enlarged view of the substrate and substrate side reference mark showing extreme rays of the projection and alignment beams;
Figure 5 is a diagram of an arrangement for generating a moving interference pattern as a reference mark; and
Figure 6 depicts an intensity pattern detected in an embodiment of the invention.

In the Figures, corresponding reference symbols indicate corresponding parts.

### Embodiment 1

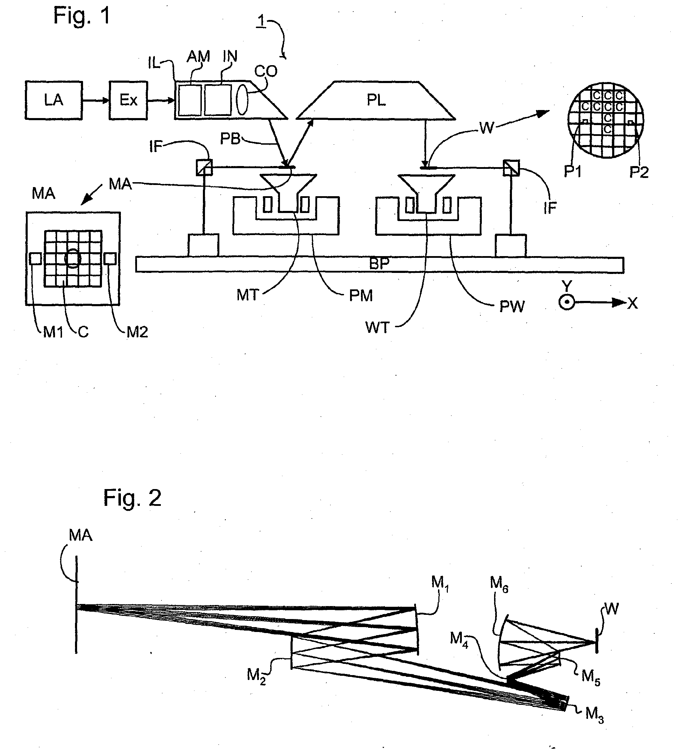

Figure 1 schematically depicts a lithographic projection apparatus according to a particular embodiment of the invention. The apparatus comprises:
. a radiation system Ex, IL, for supplying a projection beam PB of radiation (*e.g.* EUV radiation), which in this particular case also comprises a radiation source LA;
. a first object table (mask table) MT provided with a mask holder for holding a mask MA (*e.g.* a reticle), and connected to first positioning means PM for accurately positioning the mask with respect to item PL;
. a second object table (substrate table) WT provided with a substrate holder for holding a substrate W *(e.g.* a resist-coated silicon wafer), and connected to second positioning means PW for accurately positioning the substrate with respect to item PL;
. a projection system ("lens") PL (comprising a mirror group) for imaging an irradiated portion of the mask MA onto a target portion C *(e.g.* comprising one or more dies) of the substrate W.
As here depicted, the apparatus is of a reflective type *(e.g.* has a reflective mask). However, in general, it may also be of a transmissive type, for example *(e.g.* with a transmissive mask). Alternatively, the apparatus may employ another kind of patterning means, such as a programmable mirror array of a type as referred to above.

The source LA *(e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

Figure 2 shows the mask MA, projection system PL mounted on reference frame RF and substrate W. The projection system PL comprises several reflectors, e.g. six, which direct and focus the projection beam PB to project a reduced image of the mask pattern in mask MA onto the substrate W. The arrangement of reflectors in a projection system that may be used in the present invention in shown in Figure 2. Further details of this, and other possible systems are given in EP 1 209 503 which document is incorporated herein by reference. The positions and orientations of the reflectors, and particularly any changes therein, affect the position of the projected image and may also distort the image in other ways. For example, a shift in position of one or more reflectors can affect the magnification of the projected image. To minimize distortions and displacements of the projected image, which of course will result in errors in the device being manufactured, the reflectors are held in active mounts and their positions relative to the reference frame RF are thereby maintained as stable as possible. The positions of the mask MA and substrate W are also controlled relative to the reference frame RF.

However, in spite of this active control, undesirable errors and disturbances in the positions of the reflectors may occur and it is desirable to be able to detect these, and preferably correct or compensate for any resulting shift of the projected image and/or distortion in the projected image. Reflector alignment systems 10 and 20 are therefore provided. These systems use alignment beams AB1, AB2 which propagate through the projection system PL, being reflected by the reflectors of the projection system, to measure the apparent relative positions of markers 11, 21 provided on the mask side of the projection system PL and markers 14, 24 on the substrate side. Markers 11, 14, 21, 24 are fixed relative to each other and preferably to the reference frame RF. Any change in the position or orientation of a reflector in the projection lens will manifest itself as a change in the apparent relative position of the markers and is detected by the alignment systems 10, 20.

In this embodiment, the markers 11, 14, 21, 24 and folding mirrors 12,13, 22, 23, which direct the alignment beams to and from the markers into the projection system PL, are positioned so that the mask side markers are in planes optically congruent with the object plane of the projection lens and the substrate side markers are in planes optically congruent with the image plane. With this arrangement, the shift in apparent position of the markers directly corresponds to the shift in the image projected on the substrate so the position error signal may be directly applied as a correction to the mask and/or substrate positions. In other arrangements a, possibly non-linear, transformation may need to be applied to the position error signal.

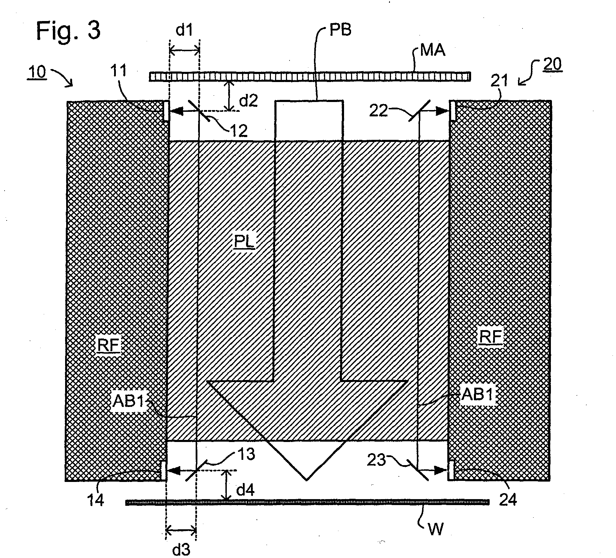

As shown in Figure 3, the optics of the alignment systems 10, 20 are such as to have a numeric aperture NA_{AB} less than the numeric aperture NA_{PB}. For example, NA_{AB} may be about 0.05 whilst NA_{PB} may be about 0.25. This means that the folding mirrors can be placed to direct the alignment beams AB1, AB2 to the markers without blocking part of the projection beam PB. In projection systems where mirror movements and/or rotations predominantly include a shift of the projected image, one reflector alignment system may suffice. However two reflector alignment systems can be used to additionally measure rotation and magnification changes whilst further systems allow measurement of higher order effects, *e.g.* third order distortions.

Figure 3 also shows that the folding mirror 13 may be formed as the angled end of a transparent rod, at the end of which is fixed marker 14, in this case comprising a grating 141 and photocell 142. Of course, the photodetector may be situated remotely and the radiation conducted to it by an optical fiber. Likewise, the source illuminating the first grating of the reflector alignment system may be situated remotely and the illumination radiation conducted to the appropriate pace by optical fiber(s). This avoids the necessity to mount potentially heat-generating components on the reference frame, which must be maintained at a constant temperature. Furthermore, the positions of the source and detector may be interchanged.

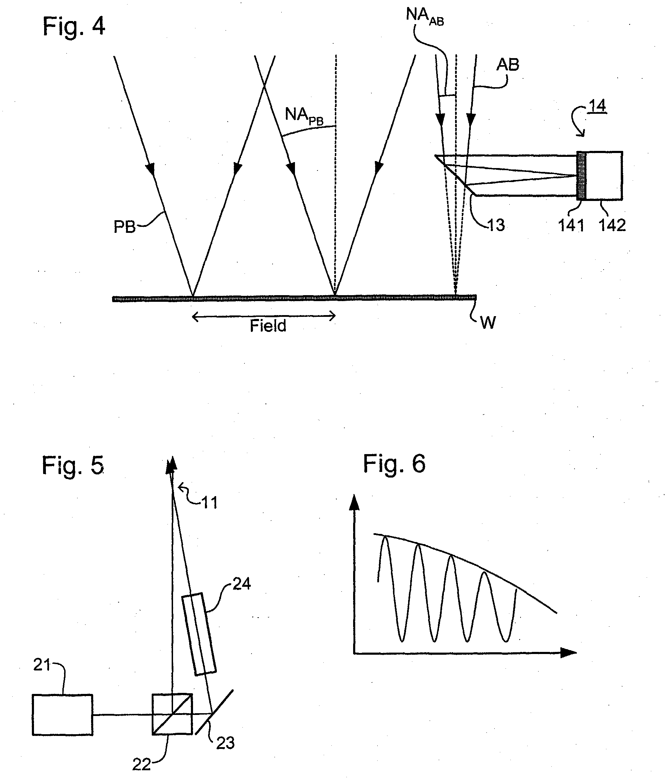

The alignment systems 10, 20 may take various different forms and in particular may be adapted from an alignment system used to make through-the-lens (TTL) alignments between reference marks provided in the mask and on the substrate. In one such alignment system, the reference markers are formed as gratings and an image of one grating is projected onto the other. A photocell is positioned behind the second grating and the intensity of the signal output by it is monitored whilst the markers are scanned relative to one another. Clearly, in the present invention which uses fixed markers it is not possible to perform such a relative scan. Instead, one of the markers can be formed by a running interference pattern between two inclined beams. Figure 4 illustrates an arrangement for producing such an interference pattern. A coherent light source 21, e.g. a visible light laser, emits a beam which is split in two sub-beams by beam splitter 22. One sub-beam is then directed by folding mirror 23 through electro-acoustic modulator 24. An interference pattern is formed in the region of overlap and this forms one reference marker 11. The spacing of the interference pattern is determined by the wavelength of the radiation used and the angle of overlap between the two sub-beams. Electro-acoustic modulator 24 introduces a variable phase delay in one sub-beam which causes the interference pattern to move in a controllable fashion. Further information about such an arrangement is given in ' US 5,485,272 which document is incorporated herein by reference.

An alternative to form a running interference pattern is to use a Zeeman laser which emits a beam containing two components of different wavelengths at a separation determined by the strength of a magnetic field applied to the laser cavity. The two components are circularly polarized with opposite senses and can therefore be separated using a polarizing beam splitter and caused to interfere using waveplates and polarizers or by ensuring that one component undergoes an odd number of reflections more than the other.

Another alignment system which does not need a relative scan of the gratings uses projection gratings of slightly different pitches. This results in a beat signal, like that shown in Figure 6, which can be detected with a detector such as a CCD array. A phase change between the two gratings, *e.g.* caused by a relative displacement, results in a similar phase change in the beat signal. The phase change in the beat is easy to detect because it has a larger period.

A further alternative alignment system uses a modulation technique to enable a static or zero-measurement with low noise levels. For example, light incident on the detector grating is split into two equal components, using a direfringent material that separates the light into ordinary (o) and extraordinary (e) components. This results in two relatively displaced images of the projection grating on the detection grating. An optical modulator *(e.g.* working on the photo-elasticity principle) lies between the detection grating and the detector and alternately passes the o and e components. The difference between the o and e signals is related to the relative displacement between projection and detection gratings. This type of detector is further described in US 4,251,160 which document is incorporated herein by reference.

It should be noted that the wavelength of the alignment beams does not have to be the same as that of the projection beam. The reflectivities of reflectors in the projection system PL are optimized for the wavelength of the projection beam but the reflectors will still have reasonably high reflectivities at other wavelengths, e.g. visible and ultraviolet. Use of a sufficiently powerful source and a sensitive detector can ensure a useable signal even where there are very large losses in the projection system PL.

If a scanning marker is not necessary and the alignment system can cope with the losses, one of the markers can be replaced with a retro-reflector such as a cat's eye or corner cube so that the alignment beam makes two passes through the projection system, doubling the measurement accuracy.

Whilst specific embodiments of the invention have been described above, it will be appreciated that the invention may be practiced otherwise than as described. The description is not intended to limit the invention. For example, the invention may be used in an apparatus having a catadioptric projection system instead of a wholly reflective projection system.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
**characterized by**:
- a reflector alignment system for directing an alignment beam of radiation through said projection system to measure the apparent relative positions of a first reference mark provided in a fixed position on the patterning means side of said projection . system and a second reference mark provided in a fixed position on the substrate side of the projection system.

2. Apparatus according to claim 1 wherein the numeric aperture of the alignment system is smaller than that of the projection system.

3. Apparatus according to claim 1 or 2 wherein said reference marks comprise gratings.

4. Apparatus according to claim 1, 2 or 3 wherein one of said reference marks comprises a running fringe pattern formed by interference between two beams intersecting at an angle.

5. Apparatus according to claim 1, 2, 3 or 4 wherein said reference marks are provided in planes congruent with the object and image planes of the projection system.

6. Apparatus according to any one of the preceding claims further comprising control means, responsive to said reflector alignment system, for controlling the position of the patterning means and/or the substrate to compensate for or alleviate errors detected by said reflector alignment system.

7. Apparatus according to any one of the preceding claims, further comprising a second reflector alignment system for directing a second alignment beam of radiation through said projection system to measure the apparent relative positions of a third reference mark provided in a fixed position on the patterning means side of said projection system and a fourth reference mark provided in a fixed position on the substrate side of the projection system, said second alignment beam propagating through said projection system along a different optical path than the first-mentioned alignment beam.

8. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system comprising a plurality of reflectors,
**characterized by** the step of
- detecting positional errors or disturbances of the reflectors in said projection system by directing an alignment beam through the projection system to measure the apparent relative positions of first and second reference marks provided respectively at the patterning means side and the substrate side of said projection system.
